# EUROPÄISCHE PATENTSCHRIFT

(11) **EP 3 054 754 B1**
(45) Veröffentlichungstag und Bekanntmachung des Hinweises auf die Patenterteilung: **11.12.2019**
(21) Anmeldenummer: 16154416.8
(22) Anmeldetag: 05.02.2016
(51) Int. Cl.: H05K 7/14, H01R 13/453, H01R 9/26, H01R 13/52, H01R 24/64

(54) **GEHÄUSE FÜR EINE ELEKTROBAUGRUPPE ZUR TRAGSCHIENENMONTAGE SOWIE REIHENEINBAUGERÄT**
HOUSING FOR AN ELECTRO ASSEMBLY FOR RAIL MOUNTING AND ROW INSTALLATION DEVICE
BOITIER POUR UN BLOC ELECTRIQUE DESTINE AU MONTAGE SUR RAIL PORTEUR ET APPAREIL MODULAIRE

(30) Priorität: 09.02.2015 DE 102015202285; 11.02.2015 DE 102015202439
(43) Veröffentlichungstag der Anmeldung: 10.08.2016
(73) Patentinhaber: Power Plus Communications AG, 68167 Mannheim (DE)
(72) Erfinder: Veselcic, Marko, 67122 Altrip (DE)
(74) Vertreter: Patent- und Rechtsanwälte Ullrich & Naumann

(56) Entgegenhaltungen:
- CN-Y- 201 146 280
- DE-A1-102013 100 441
- US-A1- 2013 072 042
- US-A1- 2013 260 582
- US-B1- 6 482 019
- US-B1- 7 273 383

## Beschreibung

Die Erfindung betrifft ein Gehäuse für eine Elektrobaugruppe zur Montage auf einer Tragschiene, wobei das Gehäuse eine der Tragschiene zugewandte Seite - Montageseite - und eine Frontseite aufweist, wobei das Gehäuse mindestens eine Öffnung aufweist, durch die ein Einbausteckverbinder der Elektrobaugruppe zum Einstecken eines korrespondierenden Steckverbinders erreichbar ist, wobei bei der Öffnung eine Verschlussklappe angeordnet ist, die in einer ersten Position die Öffnung verschließt, wobei die Verschlussklappe zum Freigeben des Einbausteckverbinders um eine Schwenkachse in eine zweite Position schwenkbar ist, und wobei die Verschlussklappe in der zweiten Position zumindest zur Hälfte in einer Vertiefung in einer der Wandungen des Gehäuses angeordnet ist. Die Erfindung betrifft ferner ein Reiheneinbaugerät mit einem Gehäuse zur Montage auf einer Tragschiene und einer Elektrobaugruppe.

Reiheneinbaugeräte sind elektrische und/oder elektronische Geräte, die ein Gehäuse zur Montage auf einer Tragschiene und eine in diesem Gehäuse angeordnete Elektrobaugruppe aufweisen, wobei die Elektrobaugruppe die eigentliche Funktion des Reiheneinbaugeräts erfüllt. Auf der Tragschiene lassen sich mehrere Reiheneinbaugeräte direkt nebeneinander anordnen. Die in Europa vermutlich am weitesten verbreiteten Tragschienen sind Hutschienen nach EN 50022 (auch bekannt als DIN Rail), die insbesondere in Elektroverteilern eingesetzt werden. In Deutschland sind die Abmessungen von zugehörigen Gehäusen und deren Einbaumaße nach DIN 43880 genormt. Danach ist die Oberfläche einer Berührungsschutzabdeckung im Abstand von 52 mm von der Oberkante der Hutschiene angeordnet, die die Kontakte der einzelnen Hutschienengehäuse gegen Berührung und Manipulation schützen. Ein Teil des Hutschienengehäuses ragt durch eine dafür in der Berührungsschutzabdeckung vorgesehene Öffnung und/oder ist durch diese Öffnung sichtbar. Dieser Teil ist in einer Richtung senkrecht zur Hutschiene 45 mm breit. Das Hutschienengehäuse selbst darf die Berührungsschutzabdeckung bei Baugröße 1 maximal um 10 mm überragen, so dass das Hutschienengehäuse von der Oberkante der Hutschiene gemessen maximal 62 mm hoch sein darf. Im Abstand von mindestens 70 mm von der Hutschiene ist eine Türe oder eine andere Frontverkleidung angeordnet, die den gesamten Verteiler mit den einzelnen Hutschienengehäusen und der Berührungsschutzabdeckung abschließt. Innerhalb dieser Vorgaben muss sich ein normgerecht aufgebautes Hutschienengehäuse bewegen. Bei anderen Tragschienensystemen gelten ähnliche Vorgaben.

Die Seite des Gehäuses, die der Tragschiene zugewandt ist und an der oder in der eine Aufnahme für die Tragschiene ausgebildet ist, wird nachfolgend auch als Montageseite bezeichnet. Zudem umfasst das Gehäuse eine Frontseite, die im montierten Zustand des Gehäuses sichtbar bleibt. Im Falle eines Hutschienengehäuses ist die Frontseite die Seite des Gehäuses, die vor der Berührungsschutzabdeckung, d.h. relativ zu der Hutschiene auf der gegenüberliegenden Seite der Berührungsschutzabdeckung, liegt, parallel zu der Berührungsschutzabdeckung bzw. parallel zu der Montageseite angeordnet ist und durch die Öffnung in der Berührungsschutzabdeckung ragt.

Aus der Praxis ist eine Vielzahl von Reiheneinbaugeräten bekannt, die Einbausteckverbinder, meist in Form von Einbaubuchsen, aufweisen. Der Einbausteckverbinder ist üblicherweise durch eine Öffnung in dem Gehäuse des Reiheneinbaugeräts erreichbar, um einen korrespondierenden Steckverbinder in den Einbausteckverbinder einzustecken. Bei einer Einbaubuchse ist der korrespondierende Steckverbinder ein Stecker. Die Einbausteckverbinder sind abhängig von ihrem jeweiligen Verwendungszweck unterschiedlich ausgestaltet. Insbesondere bei IP (Internet Protocol)-basierter Kommunikation haben sich RJ (Registered Jack)-Steckverbinder etabliert, die von der US-amerikanischen FCC (Federal Communications Commission) genormt sind. Bei kupferkabel-gebundener Kommunikation über Ethernet ist insbesondere RJ45 weit verbreitet, bei dem bei Vollbeschaltung acht Kontaktpositionen mit acht Kontakten vorgesehen sind (8P8C-Modularstecker bzw. -buchse) und dessen Verkabelung nach EIA/TIA-568 standardisiert ist.

Derartige Reiheneinbaugeräte können eine Vielzahl von Funktionen erfüllen. Beispielhaft sei auf einige Reiheneinbaugeräte in Form von Kommunikationseinheiten mit einer RJ45-Einbaubuchse in der Frontseite hingewiesen, nämlich auf IP-Gateways für Türsprechanlagen (beispielsweise von der Firma Gira), IP-Gateways oder andere Interfaces für einen KNX-Bus (beispielsweise von der Firma Weinzierl Engineering GmbH) oder SmartMeter-Gateways. Auf letztere wird nachfolgend noch genauer eingegangen.

In Deutschland sind gewisse Anforderungen an ein SmartMeter-Gateway in dem Gesetz über die Elektrizitäts- und Gasversorgung (EnWG) und dort insbesondere die §§ 21e, 21f und 21i vorgeschrieben, die in einem Schutzprofil und einer Technischen Richtlinie des Bundesamts für Sicherheit in der Informationstechnik (BSI) konkretisiert sind. Die Aufgabe eines SmartMeter-Gateways besteht darin, eine verschlüsselte Kommunikation zwischen einem SmartMeter und dem Versorgungsunternehmen (Energie, Wasser, etc.) sowie eine Beschränkung des Zugriffs auf bekannte Teilnehmer und Geräte sicherzustellen. Hierzu weist das SmartMeter-Gateway mehrere Schnittstellen auf, insbesondere eine Schnittstelle zu einem WAN (Wide Area Network), eine Schnittstelle zu einem LMN (Local Metrological Network) und eine Schnittstelle zu einem HAN (Home Area Network). Die HAN-Schnittstelle ist für den Endkunden vorgesehen, um beispielsweise Verbrauchs- und/oder Einspeisewerte abzufragen. Gleichzeitig können über die HAN-Schnittstelle steuerbare Geräte angesteuert werden oder ein Techniker kann einen Systemstatus abfragen. Daher ist die HAN-Schnittstelle im Gehäuse für einen Endkunden zugänglich angeordnet, d.h. ein zugehöriger Anschluss, meist eine RJ45-Buchse, liegt an der Frontseite des Gehäuses vor der Berührungsschutzabdeckung.

Insbesondere bei Einbausteckverbindern in der Frontseite ist es wünschenswert, den Einsteckbereich zum Schutz vor Verschmutzung abzudecken, wenn in dem Einbausteckverbinder kein Steckverbinder eingesteckt ist. Hierzu sind entfernbare Verschlüsse bekannt, die bei Nichtnutzung des Einbausteckverbinders diesen abdecken und hierzu üblicherweise zumindest teilweise in dessen Einsteckbereich eingesteckt werden. Bei Nutzung des Einbausteckverbinders werden derartige Verschlüsse entfernt und geben den Einsteckbereich frei. Diese Ausgestaltung ist insbesondere dahingehend nachteilig, dass derartige Verschlüsse nach dem Entfernen von dem Einsteckverbinder häufig verloren gehen.

Andere Verschlüsse sind als Verschlussklappen ausgestaltet, die in einer Position den Einbausteckverbinder abdecken und zur Freigabe des Einbausteckverbinders in einer zweite Position verschwenkbar sind. Eine derartige Verschlussklappe kann beispielsweise der DE 102014 100441 A1 entnommen werden. Im geöffnetem Zustand kann die Verschlussklappe zusätzlich zur Sicherung des eingesteckten Steckverbinders verwendet werden, indem ein Kabelbinder Stege an dem Gehäuse, den Steckverbinder und die geöffnete Verschlussklappe umgreift. Nachteilig hieran ist, dass die Verschlussklappe in geöffnetem Zustand relativ weit von dem Gehäuse absteht und damit beispielsweise bei einem Hutschienengehäuse nicht selten die vorgegebenen Abmessungen des Gehäuses überschreiten. Zudem besteht die Gefahr, dass die Verschlussklappe bei Arbeiten in der Nähe des Reiheneinbaugeräts abbricht.

Der vorliegenden Erfindung liegt daher die Aufgabe zugrunde, ein Gehäuse und ein Reiheneinbaugerät der eingangs genannten Art derart auszugestalten und weiterzubilden, dass ein sicheres Verschließen eines Einbausteckverbinders bei dessen Nichtnutzung und gleichzeitig ein sicheres und verlustfreies Verstauen des Verschlusses bei Nutzung des Einbausteckverbinders ermöglicht ist.

Erfindungsgemäß wird die voranstehende Aufgabe durch die Merkmale des Anspruchs 1 gelöst. Danach ist das in Rede stehende Gehäuse dadurch gekennzeichnet, dass zum Erreichen einer Schwenkbarkeit der Verschlussklappe ein Scharniergelenk ausgebildet ist, dass bei einer Scharnieraufhängung des Scharniergelenks eine Dichtung angeordnet ist, die eine nach Einsetzen der Verschlussklappe in eine Scharnieröffnung verbleibende Öffnung abdichtet, wobei das Scharniergelenk vorzugsweise durch Stifte an einem Randbereich der Verschlussklappe und eine korrespondierende Scharnieraufhängung an dem Gehäuse bei der Öffnung gebildet ist, wobei die Stifte auf der Schwenkachse angeordnet sind.

Hinsichtlich eines Reiheneinbaugeräts ist die voranstehende Aufgabe durch die Merkmale des Anspruchs 13 gelöst.

In erfindungsgemäßer Weise ist zunächst erkannt worden, dass eine gute Verstaubarkeit der Verschlussklappe dadurch erreicht werden kann, dass in dem Gehäuse eine Vertiefung ausgebildet ist, die zum Aufnehmen von zumindest einem Teil der Verschlussklappe ausgebildet ist. Dabei sind Verschlussklappe, abzudeckende Öffnung und Vertiefung derart relativ zueinander angeordnet und derart aufeinander abgestimmt, dass die Verschlussklappe in einer ersten Position die Öffnung verschließt und nach Schwenken um eine Schwenkachse in eine zweite Position den Einbausteckverbinder freigibt und in der zweiten Position zumindest teilweise in der Vertiefung angeordnet ist. Hierzu kann die Vertiefung korrespondierend zu der Verschlussklappe ausgebildet sein, beispielsweise hinsichtlich der Berandung der Vertiefung. Zum Vermeiden eines Abbrechens der Verschlussklappe und zum Reduzieren einer Beeinträchtigung durch eine aufgeklappte Verschlussklappe ist die Verschlussklappe in der zweiten Position zumindest zur Hälfte in der Vertiefung angeordnet. Durch diese Ausgestaltung ist es möglich, die Öffnung sicher zu verschließen und nach Freigeben der Öffnung die Verschlussklappe sicher in der zweiten Position zu verstauen.

"Zur Hälfte" bedeutet in diesem Kontext, dass in einer Richtung senkrecht zur Schwenkachse mindestens 50% der Verschlussklappe in der Vertiefung angeordnet sind. D.h. in den meisten Fällen, dass von dem Bereich der Verschlussklappe, der zum Bilden der Schwenkachse beiträgt, bis zu dem gegenüberliegenden Ende der Verschlussklappe in Richtung senkrecht zur Schwenkachse maximal 50% der Verschlussklappe, im Normalfall die 50% an der der Schwenkachse gegenüberliegenden Seite der Verschlussklappe, aus der Vertiefung herausragt. Auch wenn bevorzugter Weise die Verschlussklappe in der zweiten Position unterhalb oder maximal bündig zu dem Teil des Gehäuses, der die Berandung der Vertiefung bildet, angeordnet ist, so ist es dennoch möglich, dass die Verschlussklappe über eine durch die Berandung gebildeten Ebene hinausragt. Dieser hinausragende Teil der Verschlussklappe ist nicht im Sinne der mindestens 50% zu verstehen.

Bevorzugter Weise ist die Verschlussklappe im Wesentlichen rechteckig ausgebildet. Bei einer der kurzen Seiten ist die Schwenkachse angeordnet. Die Richtung senkrecht zu der Schwenkachse ist damit die Richtung der langen Seite. In dieser Richtung, also entlang der langen Kante der rechteckigen Verschlussklappe ist die Verschlussklappe zu mindestens der Hälfte in der Vertiefung angeordnet, wenn die Verschlussklappe in der zweiten Position ist.

In einer bevorzugten Ausgestaltung des erfindungsgemäßen Gehäuses ist die Verschlussklappe weitgehend in der Vertiefung angeordnet. Damit ist der aus der Vertiefung herausragende Teil minimal, wenn überhaupt existent. Es ragen allenfalls kleinere Teile der Verschlussklappe, beispielsweise eine Arretierungsnase, aus der Vertiefung. Dadurch ist die Verschlussklappe in der zweiten Position besonders sicher verstaut.

Zum sicheren Halten der Verschlussklappe in der zweiten Position können die Verschlussklappe und die Vertiefung derart aufeinander abgestimmt sein, dass der in der zweiten Position in der Vertiefung angeordnete Teil der Verschlussklappe und die Vertiefung formschlüssig sind. Dies bedeutet, dass die Vertiefung in dem Bereich, in dem die Verschlussklappe bzw. Teile davon in der zweiten Position aufgenommen wird, an die Form der Verschlussklappe angepasst ist. Wenn die Verschlussklappe bei dem vorhergehenden Beispiel rechteckig ausgebildet ist, so wäre auch die Vertiefung bzw. der Bereich, in dem die Verschlussklappe in der zweiten Position angeordnet ist und den die Verschlussklappe bei der Bewegung in die zweite Position passiert, rechteckig. Dabei dürften die Abmessungen der Vertiefung nur geringfügig größer sein als die Abmessungen der Verschlussklappe.

Prinzipiell kann die Verschlussklappe in der ersten Position die Öffnung für den Einbausteckverbinder relativ beliebig verschließen. So wäre es denkbar, dass die Verschlussklappe lediglich eine Art Berührungsschutz darstellt, um beispielsweise einen empfindlichen Einbausteckverbinder vor Beschädigung zu schützen. Vorzugsweise verschließt die Verschlussklappe die Öffnung für den Einbausteckverbinder jedoch staubdicht. Durch eine derartige Ausgestaltung der Verschlussklappe kann der Einbausteckverbinder nicht nur gegenüber Berührung, sondern auch gegen das Eindringen von schädigendem Staub geschützt werden. Da die erfindungsgemäßen Tragschienengehäuse üblicherweise in Elektroverteiler eingebaut sind und diese sehr häufig im Keller oder anderen nicht allzu staubfreien Umgebungen angeordnet sind, kann dadurch der Einbausteckverbinder bei Nichtbenutzung effektiv geschützt werden.

Vorzugsweise ist staubdicht dabei im Sinne eines IP5X zu verstehen, d.h. die Verschlussklappe schützt den Einbausteckverbinder nicht vor jeglichem Eindringen von Staub, sondern bietet einen Schutz gegen Staub in schädigender Menge. IP5X ist ein "International Protection Code", eine weit verbreitete Art der Definition von Schutzarten. Diese IP-Codes sind beispielweise in DIN EN 60529, DIN 40050-9 oder ISO 20652 genormt. Die Bedeutung von "Staub in schädigender Menge" ist in der jeweiligen Norm beschrieben.

Zum Erreichen einer Schwenkbarkeit aus der ersten Position in die zweite Position bzw. umgekehrt ist ein Scharniergelenk zwischen dem Gehäuse und der Verschlussklappe ausgebildet. Dieses kann prinzipiell auf verschiedenste aus dem Stand der Technik bekannte Weisen realisiert sein. In einer bevorzugten Ausgestaltung sind jedoch zum Bilden des Scharniergelenks Stifte vorhanden, die in korrespondierende Scharnieraufhängungen eingreifen. Dabei sind die Stifte derart angeordnet, dass diese eine Schwenkachse definieren. Die Stifte können dabei am Gehäuse und die Scharnieraufhängung an der Verschlussklappe ausgebildet sein. Im Hinblick auf eine möglichst einfache Herstellbarkeit des Scharniergelenks in einem Spritzgussverfahren sind die Stifte jedoch vorzugsweise an der Verschlussklappe und die Scharnieraufhängungen an dem Gehäuse ausgebildet. In einer bevorzugten Ausgestaltung sind die Stifte dabei an einem Randbereich der Verschlussklappe und jeweils an gegenüberliegenden Seiten der Verschlussklappe ausgebildet. Mit dem Beispiel einer im Wesentlichen rechteckigen Verschlussklappe wären beispielsweise die beiden Stifte jeweils am Ende einer der kurzen Kanten der Verschlussklappe ausgebildet, wobei die Stifte eine gemeinsame Achse aufweisen.

Vorzugsweise sind die Stifte zylindrisch ausgebildet. Die Verschlussklappe kann im Bereich der Stifte eine Abstufung aufweisen, um die Zugänglichkeit der Stifte zu verbessern. Die Stifte können an dem der Verschlussklappe abgewandten Ende eine Abschrägung aufweisen. Dadurch kann das Einstecken der Verschlussklappe in die zugehörigen Scharnieraufhängungen vereinfacht werden, wobei die Abschrägungen gleichzeitig eine Art Widerhaken bilden und dadurch die Sicherheit gegenüber einem Verlust der Verschlussklappe weiter erhöhen.

Im Bereich der Scharnieraufhängung ist eine Dichtung vorgesehen, die beispielsweise durch eine angespritzte Raupendichtung ausgebildet sein kann. Die Dichtung dichtet eine auch nach Einsetzen der Verschlussklappe in die Scharnieröffnung verbleibende Öffnung geeignet ab. Zusätzlich kann eine Dichtung vorgesehen sein, die in Kontakt zu einem Einbausteckverbinder steht und den Bereich zwischen der Öffnung im Gehäuse und dem Einbausteckverbinder abdichtet. Die beiden Dichtungen können auch durch eine einzige Dichtung realisiert sein, d.h. es gibt eine Dichtung, die gleichzeitig die Scharnieröffnung und den Bereich zwischen Öffnung im Gehäuse und dem Einbausteckverbinder abdichtet. Beide Maßnahmen können - je nach Ausgestaltung der Scharnieraufhängung und/oder der Öffnung mit eingebautem Einbausteckverbinder - ein staubdichtes Abschließen des Gehäuseinneren gewährleisten, selbst wenn die Verschlussklappe in die zweite Position geschwenkt ist.

Zum sicheren Halten der Verschlussklappe in der ersten Position kann die Verschlussklappe eine Rastnase aufweisen, die an oder bei einem Randbereich der Verschlussklappe ausgebildet ist. Diese Rastnase und die Berandung der Öffnung für den Einbausteckverbinder sind dabei derart aufeinander abgestimmt, dass die Rastnase mit der Berandung der Öffnung einen Form- und/oder Kraftschluss bildet. Dadurch kann die Verschlussklappe bei Schwenken in die erste Position mit einem gewissen Kraftaufwand in die Endposition gebracht werden und es ist gleichzeitig ein gewisser Kraftaufwand notwendig, um die Verschlussklappe wieder aus der ersten Position zu bewegen. Dies gewährleistet ein sicheres Halten der Verschlussklappe in der ersten Position. Vorzugsweise erstreckt sich dabei die Rastnase über annähernd die gesamte Breite der Verschlussklappe. Bei dem Beispiel einer rechteckigen Verschlussklappe kann die Rastnase beispielsweise parallel zu der kurzen Kante der Verschlussklappe angeordnet sein und sich annähernd von der einen langen Kante zu der gegenüberliegenden langen Kante der Verschlussklappe erstrecken. Bei einer Ausbildung eines Scharniergelenks durch Stifte an der Verschlussklappe und korrespondierenden Scharnieraufhängungen an dem Gehäuse ist die Rastnase vorzugsweise an oder bei dem Randbereich der Verschlussklappe angeordnet, die dem Randbereich mit den Stiften gegenüberliegt.

Zum Erleichtern eines Schwenkens der Verschlussklappe aus der ersten Position in die zweite Position bzw. umgekehrt kann jeweils eine weitere Nase an der Verschlussklappe ausgebildet sein. Eine Nase, die beim Schwenken aus der ersten Position unterstützt, wird nachfolgend als Ausklapphilfe bezeichnet. Eine Nase, die beim Schwenken aus der zweiten Position unterstützt, wird nachfolgend als Verschlussklapphilfe bezeichnet. Die Ausklapphilfe ist dabei auf der Seite der Verschlussklappe ausgebildet, die bei der Verschlussklappe in der ersten Position der Öffnung und dem Einbausteckverbinder gegenüberliegt. Die Verschlussklapphilfe ist auf der Seite ausgebildet, die der Seite mit der Ausklapphilfe gegenüberliegt, d.h. die Seite der Verschlussklappe, die bei der Verschlussklappe in der ersten Position der Öffnung und dem Einbausteckverbinder zugewandt ist.

Vorzugsweise ist das Gehäuse derart ausgebildet, dass zum Schwenken der Verschlussklappe aus der ersten Position in die zweite Position die Verschlussklappe um einen Winkel zwischen 70° und 100°, besonders bevorzugter Weise um einen Winkel zwischen 85° und 90° verschwenkt wird. Durch diesen relativ kurzen Schwenkweg kann erreicht werden, dass ein Steckverbinder, der in dem Einbausteckverbinder eingesteckt ist, die Verschlussklappe zusätzlich schützt. Die Verschlussklappe wird dann in der zweiten Position nahe an dem Steckverbinder angeordnet sein.

Vorzugsweise ist die Öffnung, bei der sich die Verschlussklappe befindet, zumindest teilweise in einer Frontseite des Gehäuses ausgebildet.

Vorzugsweise ist die Tragschiene eine Hutschiene und das Gehäuse ein Hutschienengehäuse, das für eine typische Installationssituation gemäß DIN 43880 ausgebildet ist. Die Vertiefung für die Verschlussklappe in der zweiten Position liegt dabei vorzugsweise unterhalb einer Ebene für eine Berührungsschutzabdeckung, d.h. die tiefste Stelle in der Vertiefung liegt unterhalb der Berührungsschutzebene. Vorzugsweise liegt dabei nicht nur die Vertiefung unterhalb der Berührungsschutzebene sondern auch die Schwenkachse, um die die Verschlussklappe schwenkbar ist. Beide Maßnahmen tragen weiter dazu bei, eine Verschlussklappe zu schaffen, die in einer zweiten Position möglichst wenig störend wirkt und dort sicher verstaut werden kann.

In einer besonders bevorzugten Ausgestaltung des erfindungsgemäßen Gehäuses basiert dieses auf einem Gehäuse, wie es in der deutschen Patentanmeldung 10 2014 220 169 offenbart ist. Damit besteht das Gehäuse vorzugsweise auf zwei Teilen, die entlang einer Stoßkante zusammengefügt sind. Diese Stoßkante verläuft zumindest teilweise über die Frontseite. Im Bereich der Frontseite ist die Stoßkante gestuft ausgebildet und bildet dadurch einen Sicherungsbereich zum Anbringen eines Siegeletiketts. Vorzugweise ist die Öffnung für den Einbausteckverbinder bei der Stoßkante angeordnet. Diese Ausgestaltung erleichtert eine spritzgusstechnische Herstellung der Vertiefung sowie einer eventuell vorhandenen Scharnieraufhängung, da die Vertiefung und die Scharnieraufhängung ohne zusätzlichem Werkzeug hergestellt werden können. Die beiden Teile sind vorzugsweise im Wesentlichen gleich groß ausgebildet und - bis auf Öffnungen und die Vertiefung - vorzugsweise symmetrisch zueinander aufgebaut. Dabei verläuft die Stoßkante weitgehend in einer Ebene, die parallel zu einer Ausdehnungsrichtung einer in der Montageseite gebildeten Aufnahme für die Tragschiene und senkrecht zur Montageseite angeordnet ist.

Die Kombination aus einem erfindungsgemäßen Gehäuse und einer in dem Gehäuse angeordneten Elektrobaugruppe bildet ein erfindungsgemäßes Reiheneinbaugerät. Die Elektrobaugruppe weist dabei mindestens einen Einbausteckverbinder auf, der bei der Öffnung in dem Gehäuse angeordnet ist und in den durch diese Öffnung ein korrespondierender Steckverbinder einsteckbar ist. Das Reiheneinbaugerät kann dabei verschiedenste Funktionen erfüllen. Vorzugsweise ist das Reiheneinbaugerät jedoch eine Kommunikationseinheit, besonders bevorzugter Weise ein SmartMeter -Gateway.

In einer bevorzugten Ausgestaltung des Einbausteckverbinders ist dieser eine Einbaubuchse, wodurch der korrespondierende Steckverbinder ein Stecker ist. Die Einbaubuchse ist besonders bevorzugter Weise eine RJ45-Buchse und der Stecker ein RJ45-Stecker. Die Einbaubuchse weist eine Einstecköffnung auf. Vorzugsweise ist durch die Ausgestaltung der Einstecköffnung eine Achse definiert, entlang der ein in die Einbaubuchse eingesteckter Stecker angeordnet ist. Diese Achse schließt relativ zu der Montageseite vorzugsweise einen Winkel zwischen 9° und 30°, besonders bevorzugter Weise einen Winkel zwischen 18° und 25° ein.

Es gibt nun verschiedene Möglichkeiten, die Lehre der vorliegenden Erfindung in vorteilhafter Weise auszugestalten und weiterzubilden. Dazu ist einerseits auf die dem Anspruch 1 bzw. 13 nachgeordneten Ansprüche und andererseits auf die nachfolgende Erläuterung eines bevorzugten Ausführungsbeispiels der Erfindung anhand der Zeichnung zu verweisen. In Verbindung mit der Erläuterung des bevorzugten Ausführungsbeispiels der Erfindung anhand der Zeichnung werden auch im Allgemeinen bevorzugte Ausgestaltungen und Weiterbildungen der Lehre erläutert. In der Zeichnung zeigen
- Fig. 1: eine schematische Darstellung eines Hutschienengehäuses in Seitenansicht zur Erläuterung einer typischen Einbausituation,
- Fig. 2: eine Schrägansicht eines erfindungsgemäßen Reiheneinbaugeräts mit einer Verschlussklappe bei einer Öffnung im Gehäuse in einer ersten Position,
- Fig. 3: eine Schrägansicht des erfindungsgemäßen Reiheneinbaugeräts gemäß Fig. 2 mit der Verschlussklappe in einer zweiten Position,
- Fig. 4: eine Detailansicht des Reiheneinbaugeräts nach Fig. 2 im Bereich der Verschlussklappe,
- Fig. 5: eine Detailansicht des Reiheneinbaugeräts nach Fig. 3 im Bereich der Verschlussklappe,
- Fig. 6: verschiedene Ansichten einer Verschlussklappe, die in einem erfindungsgemäßen Gehäuse Verwendung findet,
- Fig. 7: ein Schnitt durch das erfindungsgemäßes Reiheneinbaugeräts nach Fig. 2 mit der Verschlussklappe in der ersten Position,
- Fig. 8: ein Schnitt durch das erfindungsgemäßes Reiheneinbaugeräts nach Fig. 3 mit einer Verschlussklappe in der zweiten Position,
- Fig. 9: eine Detailansicht des Schnittes nach Fig. 7 im Bereich der Verschlussklappe,
- Fig. 10: eine Detailansicht des Schnittes nach Fig. 8 im Bereich der Verschlussklappe,
- Fig. 11: eine Ansicht der Innenseite der Öffnung in einem erfindungsgemäßen Gehäuse mit Blick aus dem Gehäuseinneren heraus,
- Fig. 12: eine Schrägansicht auf die Verschlussklappe in zweiter Position gemäß Fig. 10,
- Fig. 13: eine Schrägansicht entsprechend Fig. 12 mit einer Einbaubuchse bei der Öffnung und
- Fig. 14: eine andere Schrägansicht des Bereichs nach Fig. 12 ohne Verschlussklappe.

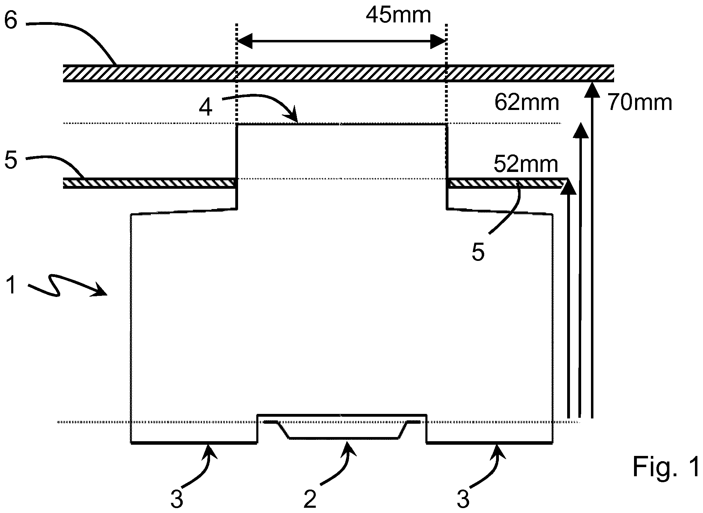

Anhand von Fig. 1 soll zunächst eine dem bevorzugten Ausführungsbeispiel zugrundeliegende Einbausituation näher betrachtet werden. Fig. 1 zeigt eine schematische Darstellung eines Hutschienengehäuses in einer Seitenansicht sowie die gemäß DIN 43880 vorgegebenen Einbaumaße für Baugröße 1 bis 3. Das Hutschienengehäuse 1 ist auf einer Hutschiene 2 montiert. Die der Hutschiene 2 zugewandte Seite des Hutschienengehäuses 1 wird nachfolgend als Montageseite 3 bezeichnet. Die der Montageseite 3 gegenüberliegende Seite wird nachfolgend als Frontseite 4 bezeichnet. Die Frontseite 4 reicht durch eine Berührungsschutzabdeckung 5, die den Bereich hinter der Berührungsschutzabdeckung, d.h. auf der Seite der Hutschiene, gegenüber Berührung und Manipulation schützt. Entsprechend ist die Berührungsschutzabdeckung in der Regel verplombt. Gemäß DIN 43880 ist die Oberfläche der Berührungsschutzabdeckung 52 mm von der Hutschiene 2 entfernt. Das Hutschienengehäuse 1 selbst darf maximal 10 mm über die Berührungsschutzabdeckung 5 hinausragen. Entsprechend ist die Frontseite 4 maximal 62 mm von der Oberkante der Hutschiene 2 entfernt. Vor der Berührungsschutzabdeckung 5 und vor der Frontseite 4 ist eine Türe 6 angeordnet, die den Verteiler, in dem die Hutschiene 2, das Hutschienengehäuse 1 und die Berührungsschutzabdeckung 5 angeordnet sind, abschließt. Die Türe 6 hat einen Abstand von 70mm von der Hutschiene 2. Die Frontseite hat eine Breite von ca. 45 mm.

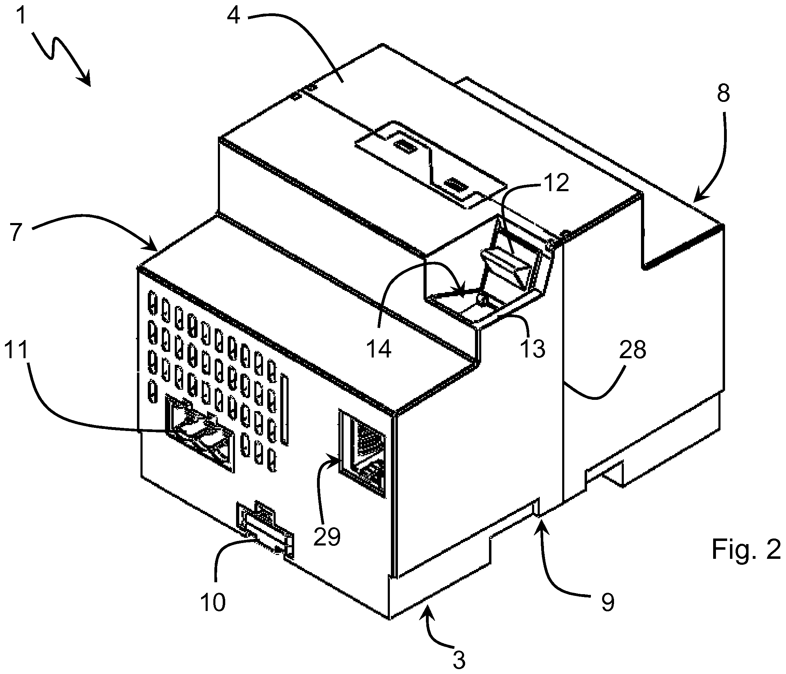

In Fig. 2 ist eine Schrägansicht eines erfindungsgemäßen Reiheneinbaugeräts in einem erfindungsgemäßen Gehäuse, in diesem Fall einem Hutschienengehäuse, dargestellt. Das Gehäuse 1 besteht aus einem ersten Teil 7 und einem zweiten Teil 8, wobei die beiden Teile 7 und 8 weitgehend symmetrisch zueinander ausgebaut sind und entlang einer Stoßkante 28 zusammengefügt sind. Im unteren Bereich des Gehäuses 1 ist durch den ersten und den zweiten Teil 7, 8 eine Aufnahme 9 für die Hutschiene (hier nicht eingezeichnet) ausgebildet. Im linken Bereich des ersten Teils 7 ist ein Rastmechanismus 10 zu erkennen, der zum Befestigen des Gehäuses 1 auf der Hutschiene ausgebildet ist. Ferner ist in dem ersten Teil 7 ein Anschluss für eine Energieversorgung 11 und eine RJ45-Einbaubuchse 29 dargestellt. Letztere ist in diesem Fall als CLS (Controllable Local System)-Interface ausgebildet, die zur HAN-Schnittstelle gehört und zum Ansteuern von regelbaren Erzeugern und unterbrechbaren Verbrauchern genutzt werden kann. In der Frontseite 4 ist am rechten Rand des ersten Teils 7 des Gehäuses 1 ein Bereich erkennbar, in dem eine Verschlussklappe 12 in einer ersten Position dargestellt ist. Die Kante 13, die eine Vertiefung 14 bei der Verschlussklappe 12 zu einer Seite berandet, ist dabei auf Niveau der Berührungsschutzabdeckung angeordnet. Damit liegt die Vertiefung 14, in der die Verschlussklappe 12 in der zweiten Position angeordnet ist, unterhalb des Niveaus der Berührungsschutzabdeckung.

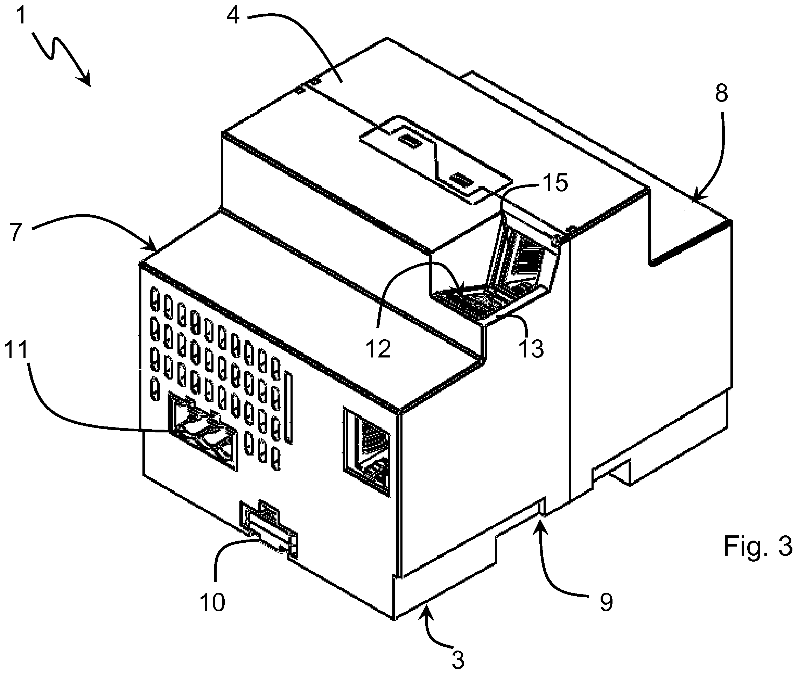

Fig. 3 stellt die identische Schrägansicht des Reiheneinbaugeräts nach Fig. 2 dar, allerdings ist hier die Verschlussklappe 12 in eine zweite Position geschwenkt. Damit ist eine Einbaubuchse 15 sichtbar und zugänglich, die als RJ45-Buchse ausgebildet ist und beispielsweise eine Schnittstelle zu einem HAN bereitstellen kann, wenn das Reiheneinbaugerät ein SmartMeter-Gateway entsprechend einer bevorzugten Ausgestaltung ist. Es ist deutlich zu erkennen, dass die Verschlussklappe 12 in der zweiten Position vollständig in der Vertiefung 14 angeordnet ist. Dadurch beeinträchtigt die Verschlussklappe 12 in der zweiten Position weder das Einstecken eines korrespondierenden Steckverbinders in den Einbausteckverbinder noch besteht Gefahr, dass die Verschlussklappe 12 beim Hantieren im Bereiche des Reiheneinbaugeräts versehentlich abbricht.

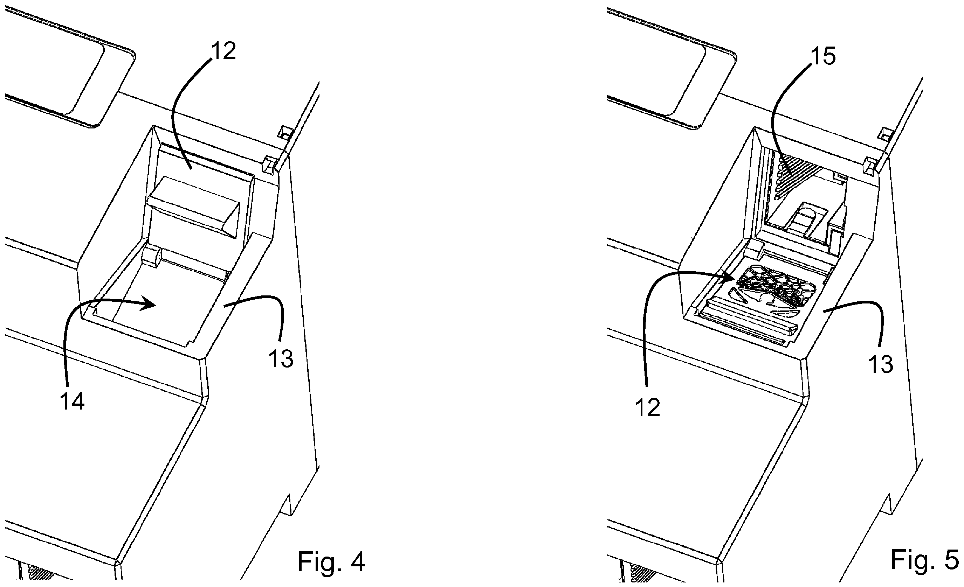

Die Figuren 4 und 5 zeigen vergrößerte Ausschnitte aus den Fig. 2 und 3 in dem Bereich um die Verschlussklappe 12, wobei Fig. 4 die Verschlussklappe 12 in der ersten Position und Fig. 5 die Verschlussklappe 12 in der zweiten Position darstellt. Es ist deutlich zu erkennen, dass die Verschlussklappe 12 in der ersten Position die Einbaubuchse 15 verschließt und damit die Einbaubuchse 15 vor Verschmutzung schützt. Befindet sich die Verschlussklappe in der zweiten Position, ist die Einbaubuchse 15 zugänglich.

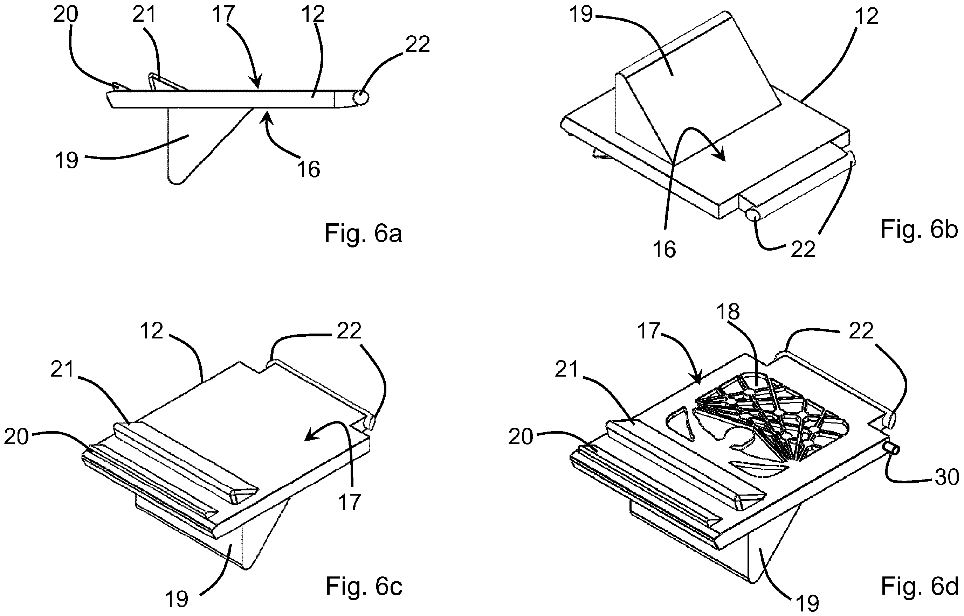

Die Figuren 6 zeigen verschiedene Ansichten einer Verschlussklappe 12 für ein erfindungsgemäßes Reiheneinbaugerät bzw. ein erfindungsgemäßes Gehäuse. Fig. 6a zeigt eine Seitenansicht der im Wesentlichen rechteckigen Verschlussklappe 12 mit Blick auch die lange Seite der Verschlussklappe. Fig. 6b zeigt eine Schrägansicht der Verschlussklappe 12 mit Blick auf die Seite 16 der Verschlussklappe, die in der ersten Position sichtbar bleibt und in der zweiten Position in Richtung Vertiefung zeigt. In Fig. 6c ist eine Schrägansicht der Verschlussklappe 12 dargestellt mit Blick auf die Seite 17 der Verschlussklappe 12, die in der zweiten Position sichtbar ist und die in der ersten Position in Richtung der Einbaubuchse 15 zeigt. Fig. 6d zeigt eine ähnliche Ausgestaltung der Verschlussklappe wie Fig. 6c, wobei in Fig. 6d auf der in der Seite 17 ein Logo 18 eingeprägt ist, das die Erkennbarkeit eines Herstellers des Reiheneinbaugeräts gewährleisten kann oder das kundenspezifische Anpassungen ermöglicht. Das Logo 18 kann auch aufgedruckt oder aufgeklebt sein.

An der Seite 16 ist eine Nase 19 - Aufklapphilfe - ausgebildet, die ein Schenken der Verschlussklappe 12 aus der ersten Position in die zweite Position vereinfacht und ein Aufklappen der Verschlussklappe ohne Werkzeug ermöglicht. An der Seite 17 sind zwei kleinere Nasen ausgebildet, wobei die in Fig. 6a am weitesten links angeordnete Nase als Rastnase 20 und die zweite Nase als Verschlussklapphilfe 21 wirken. Die Rastnase 20 ist bei einem Randbereich der Verschlussklappe 12 angeordnet. In den Fig. 6b bis 6d ist zu erkennen, dass sich die Nasen 19, 20 und 21 annähernd über die gesamte Breite der Verschlussklappe 12 erstrecken. An dem der Rastnase 20 gegenüberliegenden Randbereich der Verschlussklappe 12 sind Stifte 22 ausgebildet, die Teil eines Scharniergelenks bilden und die im montierten Zustand in korrespondierende Scharnieraufhängungen in dem Gehäuse eingreifen. Die Stifte sind an dem der Verschlussklappe abgewandten Ende leicht abgeschrägt, wodurch eine Installation der Verschlussklappe in der Scharnieraufhängung vereinfacht ist. Gleichzeitig wirkt die Abschrägung als eine Art Widerhaken, die einen sicheren Halt der Verschlussklappe 12 in dem Gehäuse gewährleisten.

Neben dem Logo ist in Fig. 6d ein weiteres Detail als bevorzugte Weiterbildung ergänzt. An einer Seite der Verschlussklappe 12 ist ein Haltestift 30 ausgebildet, der im Wesentlichen parallel zu einer durch die Stifte 22 gebildeten Achse angeordnet ist. Der Querschnitt des Haltestifts 30 ist in der dargestellten Ausbildung zylinderförmig ausgebildet, kann jedoch auch elliptisch, rechteckig, quadratisch oder in Form eines anderen Vielecks ausgebildet sein. Die Länge des Haltestiftes 30 ist derart dimensioniert, dass er - nach Einbau der Verschlussklappe 12 in das Gehäuse 1 - eine Wandung des Gehäuses berührt. Auf diese Weise entsteht eine Reibung zwischen Haltestift 30 und Wandung des Gehäuses, die einem Bewegen der Verschlussklappe 12 von der ersten Position in die zweite Position oder umgekehrt entgegenwirkt. Dies verhindert ei ungewolltes Zurückfallen der Verschlussklappe 12 zu der ersten oder der zweiten Position, wie es beispielsweise nach Einbau des Gehäuses auf der Tragschiene vorkommen kann.

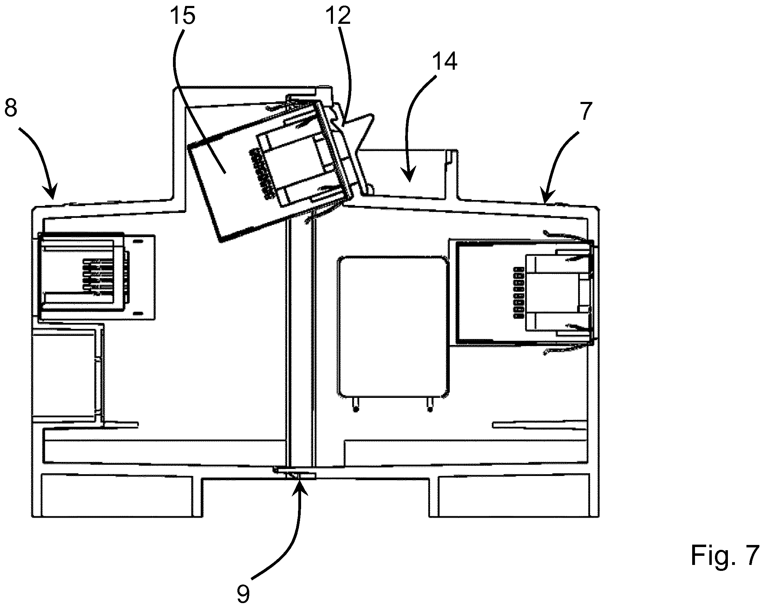

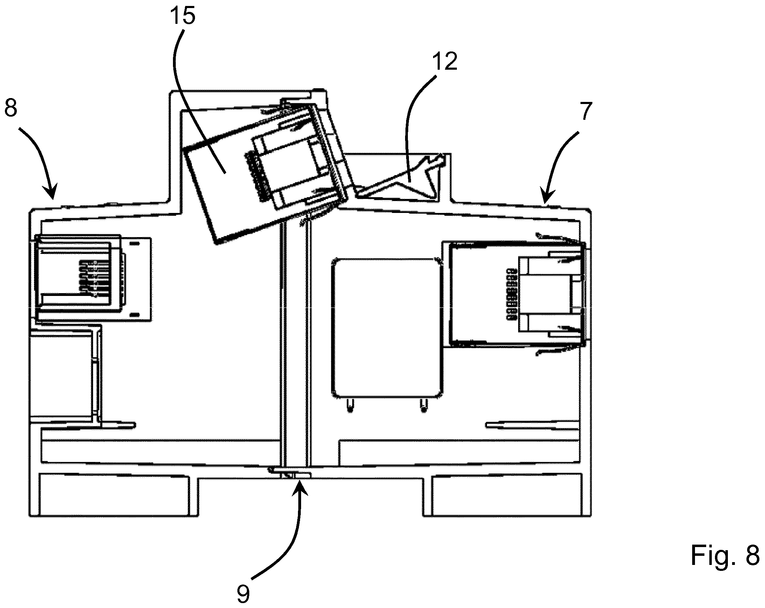

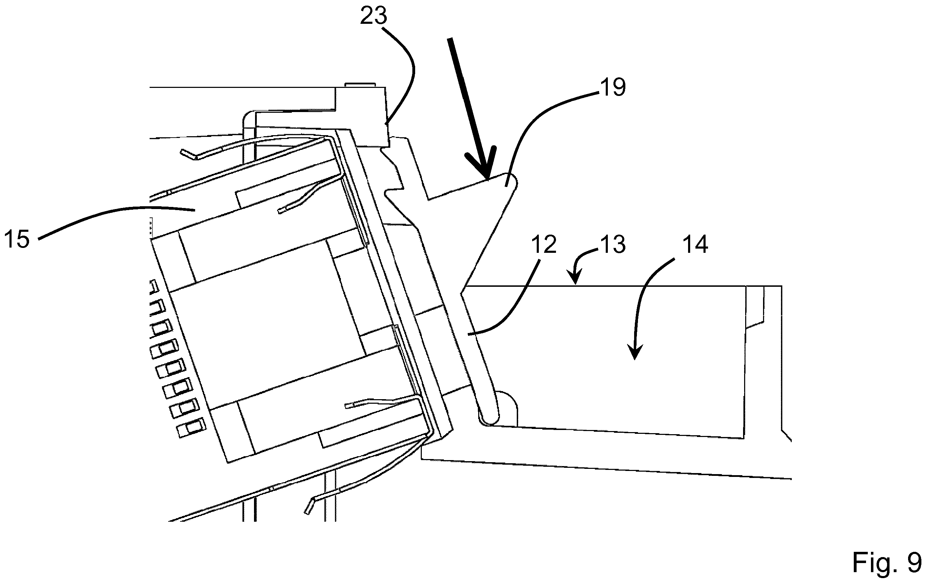

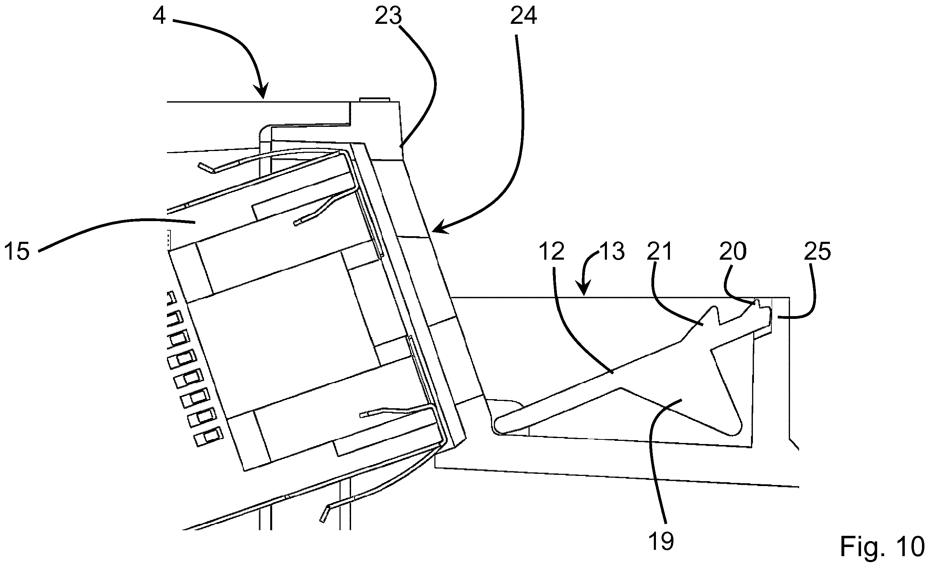

Die Figuren 7 und 8 zeigen einen Schnitt durch das erfindungsgemäße Reiheneinbaugerät, wobei die Schnittebene senkrecht zu einer Ausbreitungsrichtung der Aufnahme 9 ist. In Fig. 7 ist die Verschlussklappe 12 in der ersten Position, in Fig. 8 in der zweiten Position dargestellt. Die Figuren 9 und 10 zeigen jeweils Vergrößerungen des Bereichs um die Verschlussklappe 12. Fig. 9 zeigt wiederum die Verschlussklappe in der ersten Position, Fig. 10 in der zweiten Position.

In Fig. 9 ist zu erkennen, dass die Rastnase 20 derart ausgebildet ist, dass sie sich an einer Kante 23 des Gehäuses abstützt. Dadurch wird in der ersten Position eine kraft- und/oder formschlüssige Wechselwirkung zwischen der Rastnase 20 und der Kante 23 erreicht. Dies bewirkt, dass die Verschlussklappe 12 in der ersten Position verbleibt und nur mit gewissem Kraftaufwand aus dieser Position bewegt werden kann. Beim Aufklappen der Verschlussklappe aus der ersten Position kann die Nase 19 eingesetzt werden, wobei eine Kraft in einer Richtung ähnlich dem in Fig. 9 eingezeichneten Pfeil ausgeübt wird. Verschlussklappe und Berandung der durch die Verschlussklappe 12 in der ersten Position verschlossenen Öffnung sind dabei derart aufeinander abgestimmt, dass die Öffnung und damit die dahinterliegende Einbaubuchse 15 staubdicht verschlossen ist.

In Fig. 10 ist die Verschlussklappe 12 in die zweite Position geschwenkt, wodurch die Verschlussklappe 12 in der Vertiefung 14 angeordnet ist. Es ist zu erkennen, dass die Vertiefung 14 so ausgebildet ist, dass die Verschlussklappe 12 in der zweiten Position vollständig in der Vertiefung 14 aufgenommen ist. Damit der Randbereich der Verschlussklappe 12 bei der Rastnase 21 gut in der Vertiefung gehalten wird, ist der Randbereich der Vertiefung durch eine Verjüngung 25 verjüngt. Dadurch kann die Verschlussklappe 12 beim Bringen in die zweite Position die Verjüngung 12 geringfügig nach außen biegen, wodurch eine Haltekraft ausgebildet wird. Dabei ist die Kante der Verschlussklappe 12 weitgehend auf die Verjüngung 25 abgestimmt, wobei die Kante einen geringfügig spitzeren Winkel aufweist als für einen vollen Kontakt notwendig. Dadurch ist die Kontaktfläche geringer und die Haltekraft größer. Die Verschlussklapphilfe 21 ist in dieser Position zugänglich und unterstützt einen Nutzer, wenn die Verschlussklappe 12 aus der zweiten Position in die erste Position geschwenkt werden soll. Die Kante 13 und die obere Seite der Verjüngung 25 befinden sich - wie bereits zuvor angesprochen auf dem Niveau der Berührungsschutzabdeckung.

In den Figuren 9 und 10 ist auch eine besondere Ausrichtung der Einbaubuchse 15 in dem Reiheneinbaugerät zu erkennen. Die Einbaubuchse 15 ist so angeordnet, dass ein in der Einbaubuchse eingesteckter Stecker einen Winkel von 19° zu der Frontseite bzw. der Montageseite einschließt. Dadurch kann bei Ausgestaltung der Einbaubuchse 15 durch eine RJ45-Buchse ein Standard-RJ45-Stecker mit angespritztem Knickschutz in die Einbaubuchse 15 eingesteckt werden, ohne dass die Abmessungen für ein Hutschienengehäuse (vgl. Fig. 1) überschritten werden. Ferner ist zu erkennen, dass die Verschlussklappe 12 beim Schwenken von der ersten in die zweite Position oder umgekehrt um ca. 87° geschwenkt werden muss.

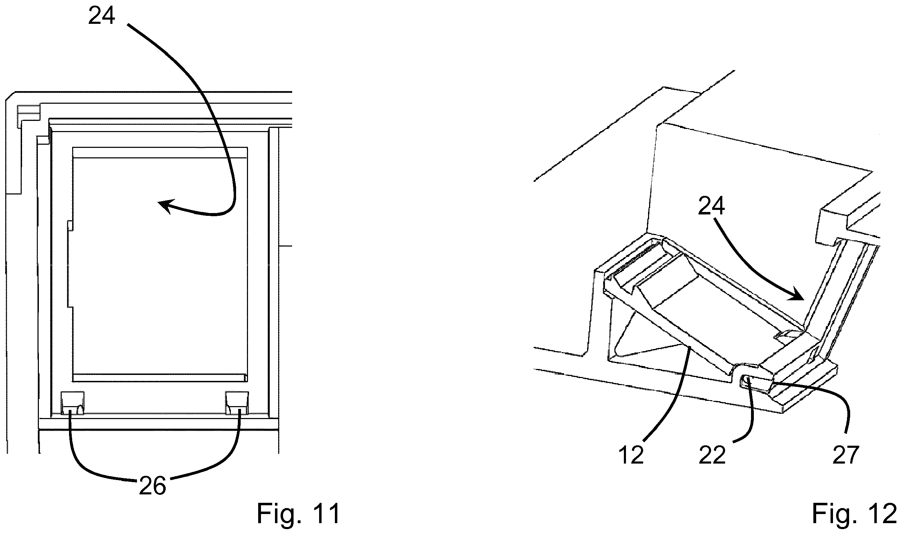

In Fig. 11 ist der Bereich des Gehäuses 1 mit der Öffnung 24 dargestellt. Die Blickrichtung auf die Öffnung 24 stellt auch die Richtung dar, aus der ein Spritzgusswerkzeug zur Herstellung des Gehäuses 1 einschließlich der Öffnung 24 und Scharnieröffnungen 26 hergestellt werden. Anders ausgedrückt kommt das Spritzgusswerkzeug aus Richtung des zu verschließenden Einbausteckverbinders. Dabei kann im Bereich der Scharnieröffnung 26 eine dünne Wandung verbleiben, so dass ohne eingesetzter Verschlussklappe von außen keine Scharnieröffnung zu erkennen ist. Diese dünne Wandung kann so dimensioniert sein, dass sie bei Einsetzen der Verschlussklappe nach außen hin verformt wird, bis der jeweilige Stift an der Verschlussklappe die Wandung durchstößt und unverlierbar in der Installationsposition verrastet. Die beiden durchstoßenen Bereiche bilden jeweils eine Scharnieraufhängung, die zusammen mit den Stiften an der Verschlussklappe ein Scharniergelenk bilden. Die Stifte 22 an der Verschlussklappe bilden die Schwenkachse, um die die Verschlussklappe 12 von der ersten in die zweite Position oder umgekehrt geschwenkt wird.

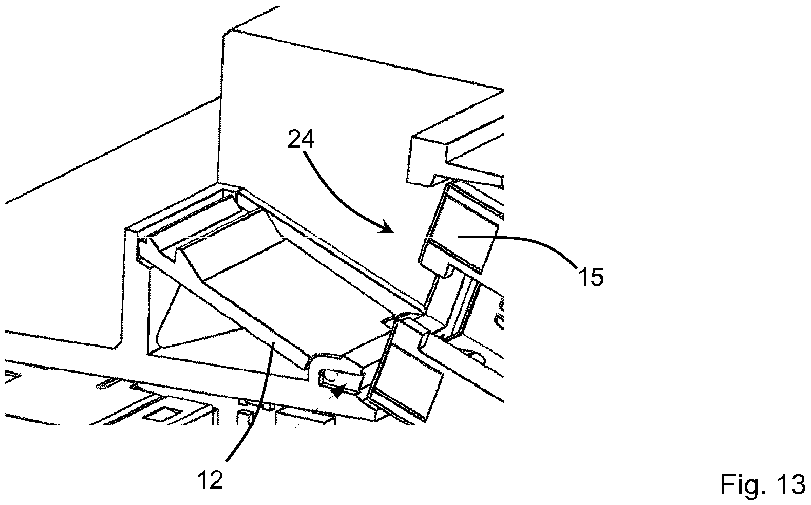

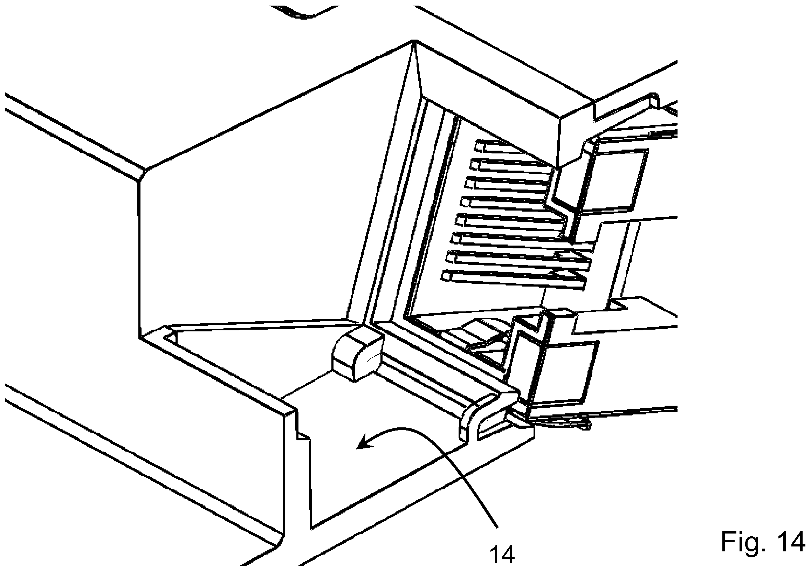

In Fig. 12 ist dieser montierte Zustand nochmals genauer zu erkennen. Die Stifte 22 an der Verschlussklappe 12 haben den Bereich bei der dünnen Wandung 27 durchstoßen und dadurch ein Scharniergelenk gebildet. In Fig. 13 ist dieser Bereich nochmals etwas vergrößert dargestellt. Zudem ist bei der Öffnung 24 eine Einbaubuchse 15 angeordnet. Der Bereich zwischen Öffnung 24 und Einbaubuchse 15 ist durch eine Dichtung, beispielsweise eine angespritzte Raupendichtung, abgedichtet. Dadurch ist auch bei einer Verschlussklappe 12 in der zweiten Position und bei einem eingesteckten Stecker in der Einbaubuchse 15 eine Staubdichtigkeit des Gehäuses gewährleistet. Fig. 14 zeigt den Bereich nochmals in einer anderen Schrägansicht. Es ist zu erkennen, dass die Scharnieröffnung noch nicht durchbrochen ist.

Hinsichtlich weiterer vorteilhafter Ausgestaltungen der erfindungsgemäßen Vorrichtung wird zur Vermeidung von Wiederholungen auf den allgemeinen Teil der Beschreibung sowie auf die beigefügten Ansprüche verwiesen.

Schließlich sei ausdrücklich darauf hingewiesen, dass die voranstehend beschriebenen Ausführungsbeispiele der erfindungsgemäßen Vorrichtung lediglich zur Erörterung der beanspruchten Lehre dienen, diese jedoch nicht auf die Ausführungsbeispiele einschränken.

### Bezugszeichenliste

- 1: Gehäuse
- 2: Hutschiene
- 3: Montageseite
- 4: Frontseite
- 5: Berührungsschutzabdeckung
- 6: Türe
- 7: Erster Teile (des Gehäuses)
- 8: Zweiter Teil (des Gehäuses)
- 9: Aufnahme (für Hutschiene)
- 10: Rastmechanismus
- 11: Anschluss für Energieversorgung
- 12: Verschlussklappe
- 13: Kante
- 14: Vertiefung
- 15: Einbaubuchse
- 16: Seite (der Verschlussklappe)
- 17: Seite (der Verschlussklappe)
- 18: Logo
- 19: Nase (Ausklapphilfe)
- 20: Rastnase
- 21: Verschlussklapphilfe
- 22: Stifte
- 23: Kante
- 24: Öffnung
- 25: Verjüngung
- 26: Scharnieröffnung
- 27: Dünne Wandung
- 28: Stoßkante
- 29: RJ45-Buchse
- 30: Haltestift

## Patentansprüche

1. Gehäuse für eine Elektrobaugruppe zur Montage auf einer Tragschiene, wobei das Gehäuse (1) eine der Tragschiene zugewandte Seite - Montageseite (3) - und eine Frontseite (4) aufweist, wobei das Gehäuse (1) mindestens eine Öffnung (24) aufweist, durch die ein Einbausteckverbinder (15) der Elektrobaugruppe zum Einstecken eines korrespondierenden Steckverbinders erreichbar ist, wobei bei der Öffnung (24) eine Verschlussklappe (12) angeordnet ist, die in einer ersten Position die Öffnung (24) verschließt, wobei die Verschlussklappe (12) zum Freigeben des Einbausteckverbinders (15) um eine Schwenkachse in eine zweite Position schwenkbar ist, und wobei die Verschlussklappe (12) in der zweiten Position zumindest zur Hälfte in einer Vertiefung (14) in einer der Wandungen des Gehäuses (1) angeordnet ist,
**dadurch gekennzeichnet, dass** zum Erreichen einer Schwenkbarkeit der Verschlussklappe ein Scharniergelenk ausgebildet ist, und
dass bei einer Scharnieraufhängung des Scharniergelenks eine Dichtung angeordnet ist, die eine nach Einsetzen der Verschlussklappe in eine Scharnieröffnung verbleibende Öffnung abdichtet, wobei das Scharniergelenk vorzugsweise durch Stifte (22) an einem Randbereich der Verschlussklappe (12) und eine korrespondierende Scharnieraufhängung an dem Gehäuse bei der Öffnung gebildet ist, wobei die Stifte (22) auf der Schwenkachse angeordnet sind.

2. Gehäuse nach Anspruch 1, **dadurch gekennzeichnet, dass** die Verschlussklappe (12) und die Vertiefung (14) derart aufeinander abgestimmt sind, dass der in der zweiten Position in der Vertiefung (14) angeordnete Teil der Verschlussklappe (12) und die Vertiefung (14) formschlüssig sind.

3. Gehäuse nach Anspruch 1 oder 2, **dadurch gekennzeichnet, dass** die Verschlussklappe (12) in der ersten Position die Öffnung (24) staubdicht, vorzugsweise staubdicht im Sinne eines IP5X, verschließt.

4. Gehäuse nach einem der Ansprüche 1 bis 3, **dadurch gekennzeichnet, dass** die Schwenkachse parallel zu einer Aufnahme (9) für die Tragschiene (2) in der Montageseite (3) angeordnet ist.

5. Gehäuse nach einem der Ansprüche 1 bis 4, **dadurch gekennzeichnet, dass** die Dichtung durch eine angespritzte Raupendichtung gebildet ist.

6. Gehäuse nach einem der Ansprüche 1 bis 5, **dadurch gekennzeichnet, dass** an einem Randbereich der Verschlussklappe (12) eine Rastnase (20) ausgebildet ist, die mit einer der Berandungen (13) der Öffnung (24) derart form- und/oder kraftschlüssig wechselwirkt, dass die Verschlussklappe (12) in der ersten Position gehalten wird, wobei sich die Rastnase (20) vorzugsweise über annähernd die gesamte Breite der Verschlussklappe (12) erstreckt.

7. Gehäuse nach einem der Ansprüche 1 bis 5 und 6, **dadurch gekennzeichnet, dass** die Rastnase (20) und die Stifte (22) an gegenüberliegenden Randbereichen der Verschlussklappe (12) angeordnet sind.

8. Gehäuse nach einem der Ansprüche 1 bis 7, **dadurch gekennzeichnet, dass** an einer Seite der Verschlussklappe (12) eine Nase (19, 21) ausgebildet ist, die ein Schwenken aus der erste Position oder aus der zweiten Position erleichtert.

9. Gehäuse nach einem der Ansprüche 1 bis 8, **dadurch gekennzeichnet, dass** die Verschlussklappe (12) zwischen der ersten Position und der zweiten Position um einen Winkel zwischen 70° und 100°, vorzugsweise zwischen 85° und 90° verschwenkbar ist.

10. Gehäuse nach einem der Ansprüche 1 bis 9, **dadurch gekennzeichnet, dass** die Öffnung (24) zumindest teilweise in einer Frontseite (4) des Gehäuses (1) ausgebildet ist, wobei die Frontseite (4) vorzugsweise der Montageseite (3) gegenüberliegend angeordnet ist.

11. Gehäuse nach einem der Ansprüche 1 bis 10, **dadurch gekennzeichnet, dass** die Tragschiene eine Hutschiene (2) und das Gehäuse (1) ein Hutschienengehäuse ist, wobei die Vertiefung (14) für die Verschlussklappe (12) in der zweiten Position vorzugsweise unterhalb einer Ebene für eine Berührungsschutzabdeckung (5) angeordnet ist.

12. Gehäuse nach einem der Ansprüche 1 bis 11, **dadurch gekennzeichnet, dass** das Gehäuse (1) aus zwei Teilen (7, 8) besteht, die entlang einer Stoßkante zusammengefügt sind, wobei die Stoßkante zumindest teilweise über die Frontseite (4) verläuft, und dass die Öffnung (24) bei der Stoßkante ausgebildet ist, wobei die Gehäuseteile (7, 8) vorzugsweise im Wesentlichen gleich groß ausgebildet sind und wobei die Stoßkante vorzugsweise im Wesentlichen in einer Ebene verläuft, die parallel zu einer Ausdehnungsrichtung einer in der Montageseite gebildeten Aufnahme (9) für die Tragschiene und senkrecht zur Montageseite (3) angeordnet ist.

13. Reiheneinbaugerät, insbesondere eine Kommunikationseinheit, mit einem Gehäuse nach einem der Ansprüche 1 bis 12 und einer innerhalb des Gehäuses angeordneten Elektrobaugruppe, wobei die Elektrobaugruppe einen Einbausteckverbinder aufweist, der durch die Öffnung in dem Gehäuse zum Einstecken eines korrespondierenden Steckverbinders erreichbar ist, wobei vorzugsweise an der Gehäuseinnenseite bei der Öffnung eine Dichtung angeordnet ist, die mit dem Einbausteckverbinder in Kontakt steht.

14. Reiheneinbaugerät nach Anspruch 13, **dadurch gekennzeichnet, dass** der Einbausteckverbinder durch eine Einbaubuchse und der korrespondierende Steckverbinder durch ein Stecker gebildet ist, dass die Einbaubuchse eine Einstecköffnung aufweist, in die der Stecker einsteckbar ist, dass durch die Einstecköffnung eine Achse definiert ist, entlang der ein eingesteckter Stecker angeordnet ist, und dass die Achse der Einstecköffnung relativ zu der Montageseite vorzugsweise einen Winkel zwischen 9° und 30°, besonders bevorzugter Weise einen Winkel zwischen 18° und 25° einschließt.

## Claims

1. Housing for an electric sub-assembly for assembly on a support rail, wherein the housing (1) has a side facing the support rail - assembly side (3) - and a front side (4), wherein the housing (1) has at least one opening (24), through which a built-in plug type connector (15) of the electric sub-assembly can be reached for inserting a corresponding plug type connector, wherein in the opening (24) there is arranged a closure flap (12), which closes the opening (24) in a first position, wherein the closure flap (12) can be pivoted about a pivot axis into a second position in order to release the built-in plug type connector (15), and wherein the closure flap (12) in the second position is arranged at least halfway in a recess (14) in one of the walls of the housing (1),
**characterised in that**, in order to achieve a pivotability of the closure flap, a hinge joint is formed, and
**in that** in a hinge suspension of the hinge joint there is arranged a seal which seals an opening which remains after the insertion of the closure flap in a hinge opening, wherein the hinge joint is preferably formed by means of pins (22) on an edge region of the closure flap (12) and a corresponding hinge suspension on the housing in the opening, wherein the pins (22) are arranged on the pivot axis.

2. Housing according to claim 1, **characterised in that** the closure flap (12) and the recess (14) are adapted to each other in such a manner that the portion of the closure flap (12) which is arranged in the second position in the recess (14) and the recess (14) are positive-locking.

3. Housing according to claim 1 or claim 2, **characterised in that** the closure flap (12) in the first position closes the opening (24) in a dust-tight manner, preferably in a dust-tight manner in the sense of an IP5X.

4. Housing according to any one of claims 1 to 3, **characterised in that** the pivot axis is arranged parallel with a receiving member (9) for the carrier rail (2) in the assembly side (3).

5. Housing according to any one of claims 1 to 4, **characterised in that** the seal is formed by means of an injection-moulded bead seal.

6. Housing according to any one of claims 1 to 5, **characterised in that** on an edge region of the closure flap (12) there is formed a locking projection (20) which interacts with one of the boundaries (13) of the opening (24) in such a positive-locking and/or non-positive-locking manner that the closure flap (12) is retained in the first position, wherein the catch projection (20) preferably extends over almost the entire width of the closure flap (12).

7. Housing according to any one of claims 1 to 5 and 6, **characterised in that** the locking projection (20) and the pins (22) are arranged on opposing edge regions of the closure flap (12).

8. Housing according to any one of claims 1 to 7, **characterised in that** at a side of the closure flap (12) there is formed a projection (19, 21) which facilitates pivoting from the first position or from the second position.

9. Housing according to any one of claims 1 to 8, **characterised in that** the closure flap (12) can be pivoted between the first position and the second position through an angle between 70° and 100°, preferably between 85° and 90°.

10. Housing according to any one of claims 1 to 9, **characterised in that** the opening (24) is formed at least partially in a front side (4) of the housing (1), wherein the front side (4) is preferably arranged opposite the assembly side (3).

11. Housing according to any one of claims 1 to 10, **characterised in that** the support rail is a top-hat rail (2) and the housing (1) is a top-hat rail housing, wherein the recess (14) for the closure flap (12) is arranged in the second position preferably below a plane for a contact protection cover (5).

12. Housing according to any one of claims 1 to 11, **characterised in that** the housing (1) comprises two portions (7, 8) which are joined along an abutment edge, wherein the abutment edge extends at least partially over the front side (4), and **in that** the opening (24) is formed at the abutment edge, wherein the housing portions (7, 8) are preferably constructed to be substantially of the same size and wherein the abutment edge preferably extends substantially in a plane which is arranged parallel with an extent direction of a receiving member (9) formed in the assembly side for the support rail and perpendicularly to the assembly side (3).

13. Modular device, in particular a communication unit, having a housing according to any one of claims 1 to 12 and an electric sub-assembly which is arranged inside the housing, wherein the electric sub-assembly has an electric plug type connector, which can be reached through the opening in the housing for inserting a corresponding plug type connector, wherein there is preferably arranged on the housing inner side in the opening a seal which is in contact with the built-in plug type connector.

14. Modular device according to claim 13, **characterised in that** the built-in plug type connector is formed by means of a built-in socket and the corresponding plug type connector is formed by means of a connector, **in that** the built-in socket has an insertion opening, in which the connector can be inserted, **in that** there is defined by the insertion opening an axis along which an inserted connector is arranged, and **in that** the axis of the insertion opening relative to the assembly side preferably defines an angle between 9° and 30°, in a particularly preferred manner an angle between 18° and 25°.

## Revendications

1. Boîtier pour un sous-ensemble électrique destiné à être monté sur un rail porteur, le boîtier (1) comprenant un côté orienté vers le rail porteur, le côté de montage (3), et un côté frontal (4), le boîtier (1) comprenant au moins une ouverture (24) permettant d'accéder à un connecteur encastrable (15) du sous-ensemble électrique pour l'insertion d'un connecteur correspondant, moyennant quoi, sur l'ouverture (24), est disposé un clapet de fermeture (12) qui, dans une première position, ferme d'ouverture (24), le clapet de fermeture (12) pouvant pivoter, pour la libération du connecteur encastrable (15), autour d'un axe de pivotement, vers une deuxième position et le clapet de fermeture (12) étant disposé, dans la deuxième position, au moins à moitié dans une cavité (14) dans une des parois du boîtier (1),
**caractérisé en ce que**, pour obtenir une capacité de pivotement du clapet de fermeture, une articulation à charnière est réalisée et
**en ce que**, dans une suspension de charnière de l'articulation à charnière, un joint d'étanchéité est disposé, qui étanchéifie l'ouverture restante dans une ouverture de charnière après l'insertion du clapet de fermeture, l'articulation à charnière étant de préférence constituée de goupilles (22) sur une zone de bord du clapet de fermeture (12) d'une suspension de charnière correspondante sur le boîtier près de l'ouverture, les goupilles (22) étant disposées sur l'axe de pivotement.

2. Boîtier selon la revendication 1, **caractérisé en ce que** le clapet de fermeture (12) et la cavité (14) sont adaptées l'un à l'autre de façon à ce que la partie du clapet de fermeture (12), disposée, dans la deuxième position, dans la cavité (14), et la cavité (14) présentent des formes complémentaires.

3. Boîtier selon la revendication 1 ou 2, **caractérisé en ce que** le clapet de fermeture (12) ferme, dans la première position, l'ouverture (24) de manière étanche à la poussière, de préférence de manière étanche à la poussière au sens d'un IP5X.

4. Boîtier selon l'une des revendications 1 à 3, **caractérisé en ce que** l'axe de pivotement est disposé parallèlement à un logement (9) pour le rail porteur (2) dans le côté de montage (3).

5. Boîtier selon l'une des revendications 1 à 4, **caractérisé en ce que** le joint d'étanchéité est un joint d'étanchéité à chenilles injecté.

6. Boîtier selon l'une des revendications 1 à 5, **caractérisé en ce que**, sur un bord du clapet de fermeture (12), est réalisé un embout d'encliquetage (20) qui interagit avec un des bords (13) de l'ouverture (24) par complémentarité de forme et/ou par force de façon à ce que le clapet de fermeture (12) soit maintenu dans la première position, l'embout d'encliquetage (20) s'étendant de préférence sur approximativement toute la largeur du clapet de fermeture (12).

7. Boîtier selon l'une des revendications 1 à 5 et 6, **caractérisé en ce que** l'embout d'encliquetage (20) et les goupilles (22) sont disposés sur des bords opposés du clapet de fermeture (12).

8. Boîtier selon l'une des revendications 1 à 7, **caractérisé en ce que**, sur un côté du clapet de fermeture (12), est réalisé un embout (19, 21) qui facilite un pivotement à partir de la première position ou à partir de la deuxième position.

9. Boîtier selon l'une des revendications 1 à 8, **caractérisé en ce que** le clapet de fermeture (12) peut pivoter entre la première position et la deuxième positon d'un angle entre 70° et 100°, de préférence entre 85° et 90°.

10. Boîtier selon l'une des revendications 1 à 9, **caractérisé en ce que** l'ouverture (24) est réalisée au moins partiellement dans un côté frontal (4) du boîtier (1), le côté frontal (4) étant disposé de préférence en face du côté de montage (3).

11. Boîtier selon l'une des revendications 1 à 10, **caractérisé en ce que** le rail porteur est un rail symétrique et le boîtier (1) est un boîtier à rail symétrique, la cavité (14) pour le clapet de fermeture (12) dans la deuxième position étant de préférence disposée en dessous d'un plan pour un couvercle anti-contact (5).

12. Boîtier selon l'une des revendications 1 à 11, **caractérisé en ce que** le boîtier (1) est constitué de deux parties (7, 8) qui sont jointes le long d'une arête de jonction, l'arête de jonction s'étendant au moins partiellement sur le côté frontal (4) et **en ce que** l'ouverture (24) est réalisée sur l'arête de jonction, les parties du boîtier (7, 8) présentant de préférence globalement la même taille et l'arête de jonction s'étendant de préférence globalement dans un plan qui est disposé parallèlement à une direction d'extension d'un logement (9), réalisé dans le côté de montage, pour le rail porteur et perpendiculairement au côté de montage (3).

13. Appareil encastrable en série, plus particulièrement une unité de communication avec un boîtier selon l'une des revendications 1 à 12 et un sous-ensemble électrique disposé à l'intérieur du boîtier, le sous-ensemble électrique comprenant un connecteur encastrable auquel il est possible d'accéder par l'ouverture dans le boîtier pour l'insertion d'un connecteur correspondant, de préférence, sur le côté intérieur du boîtier, au niveau de l'ouverture, est disposé un joint d'étanchéité qui est en contact avec le connecteur encastrable.

14. Appareil encastrable en série selon la revendication 13, **caractérisé en ce que** le connecteur encastrable est constitué d'une douille encastrable et le connecteur correspondant est constitué d'un connecteur mâle, **en ce que** la douille encastrable comprend une ouverture d'insertion dans laquelle le connecteur mâle peut être inséré, **en ce que** l'ouverture d'insertion définit un axe le long duquel est disposé un connecteur inséré et **en ce que** l'axe de l'ouverture d'insertion forme, par rapport au côté de montage, de préférence un angle entre 9° et 30°, plus particulièrement un angle entre 18° et 25°.
